(19) Europäisches Patentamt
European Patent Office
Office européen des brevets

(11) **EP 1 794 601 B1**

(12) **EUROPÄISCHE PATENTSCHRIFT**

(45) Veröffentlichungstag und Bekanntmachung des Hinweises auf die Patenterteilung:
**21.01.2015 Patentblatt 2015/04**

(21) Anmeldenummer: **05793038.0**

(22) Anmeldetag: **16.09.2005**

(51) Int Cl.:
***G01R 23/16*** *(2006.01)*

(86) Internationale Anmeldenummer:
**PCT/EP2005/010029**

(87) Internationale Veröffentlichungsnummer:
**WO 2006/034791 (06.04.2006 Gazette 2006/14)**

(54) **VERFAHREN UND VORRICHTUNG ZUR SPEKTRUMANALYSE IN MEHREREN FREQUENZBÄNDERN MIT VERSCHIEDENER FREQUENZAUFLÖSUNG**

METHOD AND DEVICE FOR ANALYSING THE SPECTRUM IN SEVERAL FREQUENCY RANGES HAVING DIFFERENT RESOLUTIONS

PROCEDE ET DISPOSITIF D'ANALYSE SPECTRALE DANS PLUSIEURS BANDES DE FREQUENCE AVEC DES RESOLUTIONS DE FREQUENCE DIFFERENTES

(84) Benannte Vertragsstaaten:
**DE FR GB**

(30) Priorität: **28.09.2004 DE 102004047044**
**21.10.2004 DE 102004051386**

(43) Veröffentlichungstag der Anmeldung:
**13.06.2007 Patentblatt 2007/24**

(73) Patentinhaber: **Rohde & Schwarz GmbH & Co. KG**
**81671 München (DE)**

(72) Erfinder:
• **FELDHAUS, Gregor**
**81669 München (DE)**
• **ECKERT, Hagen**
**86415 Mering (DE)**

(74) Vertreter: **Körfer, Thomas**
**Mitscherlich PartmbB**
**Patent- und Rechtsanwälte**
**Postfach 33 06 09**
**80066 München (DE)**

(56) Entgegenhaltungen:
**EP-A- 0 473 949      EP-A- 1 271 160**
**WO-A-2004/001998      US-A- 4 231 103**

• **ANONYMOUS: 'Aufbau und Bedienung elektrischer Spektrum-Analysatoren', [Online] 2001, ONLINE, Seiten 1 - 7 Gefunden im Internet: <URL:http://www.nari.ee.ethz.ch/teaching/GL F/GLF_KT_Beilage.pdf> [gefunden am 2013-04-29]**

EP 1 794 601 B1

## Beschreibung

Die Erfindung betrifft ein Verfahren zur Spektrumanalyse in mehreren Frequenzbändern mit verschiedener Frequenzauflösung.

Zur Ermittlung des Spektrums eines Signals in einem weiten Frequenzbereich mittels eines Spektrumanalysators bzw. eines Netzwerkanalysators wird der zu untersuchende Frequenzbereich in mehrere Frequenzbänder mit jeweils spezifischer Frequenzauflösung geteilt. Gegenüber einer technischen Lösung mit einem Frequenzband und einer Frequenzauflösung für den gesamten Frequenzbereich ergibt sich hiermit eine deutliche Reduzierung des Rechenaufwands in der Bestimmung des darzustellenden Spektrums in einem logarithmischen Frequenzachse wie auch eine erweiterte Vielfalt von Darstellungsmöglichkeiten für das zu analysierende Spektrum.

Aus der EP 1 271 160 A1 geht ein Verfahren und eine Vorrichtung zur Spektralanalyse in mehreren Frequenzbändern mit jeweils unterschiedlicher Frequenzauflösung hervor. Zur Beschleunigung der Spektralanalyse werden hierbei die Frequenzbänder in Gruppen von Frequenzbändern mit jeweils identischer Frequenzauflösung sortiert und eine Spektralanalyse in Frequenzbändern derselben Gruppe aufeinanderfolgend durchgeführt. Zum Abschluss werden die in den einzelnen Frequenzbändern jeweils ermittelten Spektren zum Gesamtspektrum zusammengefügt.

Eine alternative Beschleunigung der spektralen Erfassung eines Empfangssignals wird in der WO 2004/001998 A1 erzielt, indem das zu vermessende Empfangssignal mittels einer Frequenzweiche in einzelne benachbarte Frequenzbänder aufgeteilt wird. Die in den einzelnen Frequenzbändern jeweils enthaltenen Spektralanteile des Empfangssignals werden mittels Fourier-Transformation der für die einzelnen Frequenzbändern jeweils selektierten Signalanteile mittels eines zum jeweiligen Frequenzband gehörigen Fourier-Transformators ermittelt.

In der EP 0 473 949 A2 wird schließlich ein Netzwerkanalysator offenbart, mit dem Messparameter eines zu vermessenden Messobjekts in mehreren Messfrequenzbändern mit jeweils unterschiedlichen Genauigkeiten hinsichtlich Pegel und Frequenz erfasst und dargestellt werden.

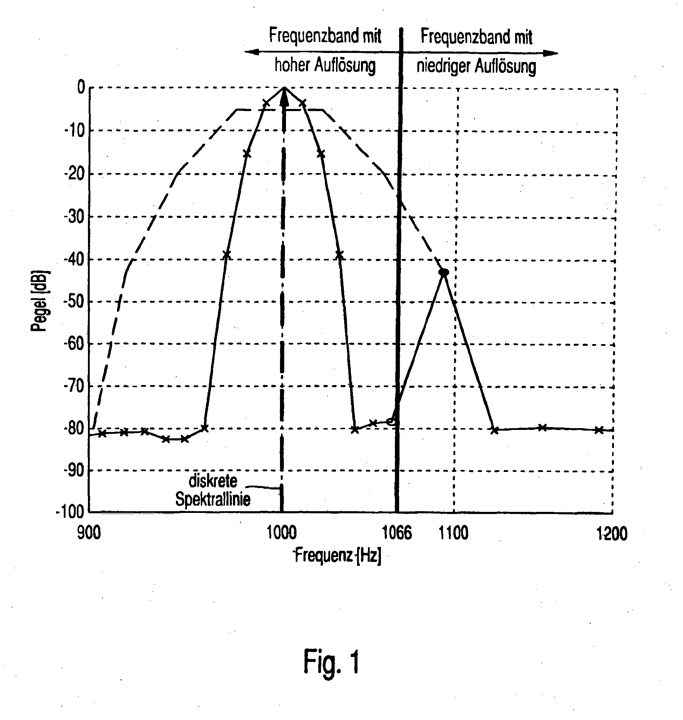

Ein wesentliches, bisher ungelöstes Problem der Spektrumanalyse in mehreren Frequenzbändern mit unterschiedlicher Frequenzauflösung ist das Auftreten von Unstetigkeiten im Übergangsbereich zwischen zwei Frequenzbändern. Diese Unstetigkeiten resultieren aus extrem schmalbandigen Spektralanteilen des zu messenden Spektrums - beispielsweise diskrete Spektrallinien von periodischen Signalanteilen im Nutzsignal oder diskrete Spektrallinien von sinusförmigen Störungen - im Übergangsbereich zwischen zwei Frequenzbändern. Falls diese diskrete Spektrallinie, wie in Fig. 1 dargestellt ist, am Rande des Frequenzbandes mit der höheren Frequenzauflösung auftritt, wird diese diskrete Spektrallinie nicht nur von der das Spektrum im Frequenzband mit der höheren Frequenzauflösung erstellenden diskreten Fourier-Analyse, sondern auch von der das Spektrum im Frequenzband mit der niedrigeren Frequenzauflösung erstellenden diskreten Fourier-Analyse identifiziert.

Wie Fig. 1 zeigt, ist das darzustellende Spektrum der diskreten Spektrallinie des sinusförmigen Störsignals aufgrund der schmalbandigen Fensterfunktion der diskreten Fourier-Analyse für das Frequenzband mit der höheren Frequenzauflösung am Rande dieses Frequenzbandes bereits abgeklungen - nicht ausgefüllter Kreis des zugehörigen Spektralwerts -, während die diskrete Fourier-Analyse für das Frequenzband mit der niedrigeren Frequenzauflösung aufgrund ihrer breitbandigeren Fensterfunktion die außerhalb des zugehörigen Frequenzbandes liegende diskrete Spektrallinie des sinusförmigen Störsignals bereits identifiziert und einen Teil des darzustellenden Spektrums des sinusförmigen Störsignals am Rande dieses Frequenzbandes - ausgefüllter Kreis des zugehörigen Spektralwerts - visualisiert.

Der Erfindung liegt deshalb die Aufgabe zugrunde, für die Spektrumanalyse in mehreren Frequenzbändern mit unterschiedlicher Frequenzauflösung Unstetigkeiten im Übergangsbereich zwischen zwei Frequenzbändern resultierend aus diskreten Spektrallinien - insbesondere einer einzigen diskrete Spektrallinie im Übergangsbereich - zu beseitigen.

Die Aufgabe der Erfindung wird durch ein Verfahren zur Spektrumanalyse eines Signals mit den Merkmalen des Anspruchs 1 gelöst.

Die unerwünschte Unstetigkeit im Übergangsbereich zwischen zwei Frequenzbändern wird im erfindungsgemäßen Verfahren und in der erfindungsgemäßen Vorrichtung durch Angleichung der beiden zu den jeweils angrenzenden Frequenzbändern gehörigen Spektren im Übergangsbereich mittels Glättung beseitigt.

Da die Glättung der beiden Spektren auf der Basis eines äquidistanten Frequenzrasters erfolgt und in den benachbarten Frequenzbändern eine unterschiedliche Frequenzauflösung der diskreten Fourier-Analyse herrscht, ist eine Angleichung der Frequenzauflösung der diskreten Fourier-Analyse zwischen den beiden Frequenzbändern durchzuführen. Da eine niedrige Frequenzauflösung nicht nachträglich in eine höhere Frequenzauflösung verbessert werden kann, wird die höhere Frequenzauflösung der diskreten Fourier-Analyse nachträglich im Übergangsbereich der beiden Frequenzbänder vom Frequenzbandinneren über eine definierten Anzahl von diskreten Spektralwerten in Richtung der Frequenzbandgrenze schrittweise verschlechtert, ohne das Frequenzraster im Frequenzband mit höherer Frequenzauflösung zu verändern.

Anstelle von komplexen Spektralwerten werden in der Glättung und anschließenden Darstellung die zugehörigen normierten Leistungswerte verwendet. Die Glättung jedes der Leistungswerte im zu betrachtenden Überlagerungsbereich erfolgt durch Gewichtung einer bestimmten Anzahl von jeweils niederfrequent und höherfrequent benachbarten Leistungswerten mit einem Gewichtungsfaktor und anschließender Addition, was insgesamt einer diskreten Faltung der zu glättenden Leistungswerte mit einer diskreten Gewichtungsfunktion entspricht.

Die Gewichtung der jeweils benachbarten Leistungswerte erfolgt mit einem Mittelungsfilter, dessen Übertragungsfunktion in Analogie zur Verwendung von Leistungswerten anstelle von Spektralwerten betragsquadriert und normiert wird.

Um einen gleichmäßigen Übergang zwischen den Frequenzbändern zu erzielen, wird die Mittelungslänge, innerhalb der die für die Glättung zu berücksichtigenden benachbarten Leistungswerte liegen, in Abhängigkeit der Frequenzlage des jeweiligen zu glättenden Leistungswertes stetig verändert. Daher ist eine entsprechende Anpassung der Filterlänge des Mittelungsfilters erfindungsgemäß vorgesehen.

Das zum zu glättenden Leistungswert an der Frequenzbandgrenze gehörige Mittelungsfilter weist folglich die größte Filterlänge auf und entspricht der Fouriertransformierten der Fensterfunktion für das Frequenzband mit der niedrigeren Frequenzauflösung und kann folglich durch diskrete Fourier-Transformation aus der Fensterfunktion ermittelt werden. Die Mittelungsfilter für die zu glättenden Leistungswerte mit größerem Frequenzabstand zur Frequenzbandgrenze weisen sukzessive eine geringere Filterlänge auf und können durch Überabtastung des Mittelungsfilters, das zum zu glättenden Leistungswert an der Frequenzbandgrenze gehört, und anschließende Nullsetzung der jeweils äussersten Spektralwerte der durch Überabtastung gewonnenen Übertragungsfunktion des Mittelungsfilters ermittelt werden.

Eine Ausführungsform des erfindungsgemäßen Verfahrens zur Spektrumanalyse eines Signals wird im folgenden unter Berücksichtigung der Zeichnung näher erläutert. In der Zeichnung zeigen:

Fig. 1          eine spektrale Darstellung des Übergangsbereich zwischen zwei Frequenzbändern,

Fig. 2          ein Blockschaltbild im Zeit- und Frequenzbereich einer diskreten Fourier-Analyse,

Fig. 3          eine spektrale Darstellung eines durch diskrete Fourier-Analyse ermittelten Spektrums eines periodischen Signalanteils eines Meßsignals bei unterschiedlicher Fensterlänge,

Fig. 4          eine Darstellung der Frequenzrasterung zweier angrenzender Frequenzbänder,

Fig. 5A, 5B, 5C, 5D, 5E          eine spektrale Darstellung der betragsquadrierten Übertragungsfunktion der Fensterfunktion für das höherfrequente Frequenzband und von Mittelungsfiltern unterschiedlicher Filterlänge,

Fig. 6          ein Flußdiagramm eines erfindungsgemäßen Verfahrens zur Spektrumanalyse eines Signals,

Fig. 7          ein Blockschaltbild einer Vorrichtung zur Spektrumanalyse eines Signals und

Fig. 8A, 8B, 8C, 8D          eine spektrale Darstellung des Übergangsbereich zwischen zwei Frequenzbändern nach erfindungsgemäßer Glättung einer unterschiedlichen Anzahl von Leistungswerten.

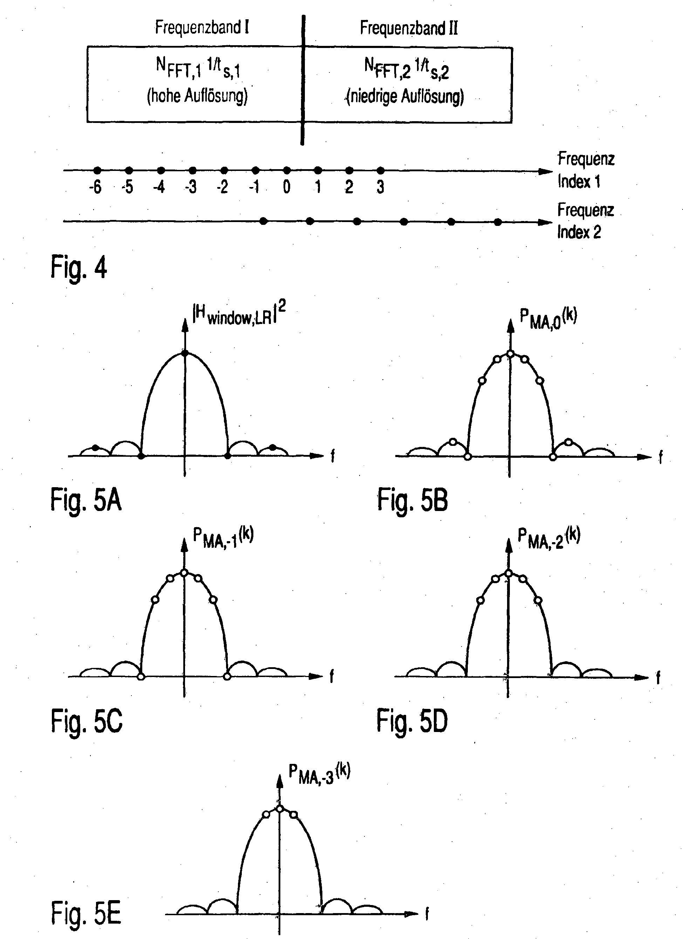

Bevor in den Figuren 4, 5A, 5B, 5C, 5D, 5E, 6, 7, 8A, 8B, 8C und 8D das erfindungsgemäße Verfahren und eine entsprechende Vorrichtung zur Spektrumanalyse eines Signals im Detail beschrieben wird, erfolgt im folgenden eine Beschreibung der für das Entstehen von Unstetigkeiten im Übergangsbereich zwischen zwei Frequenzbändern mit jeweils unterschiedlicher Frequenzauflösung verantwortlichen Wirkungszusammenhänge. Darauf aufbauend werden die mathematischen Grundlagen für das Verständnis des erfindungsgemäßen Verfahrens im Detail aufgezeigt.

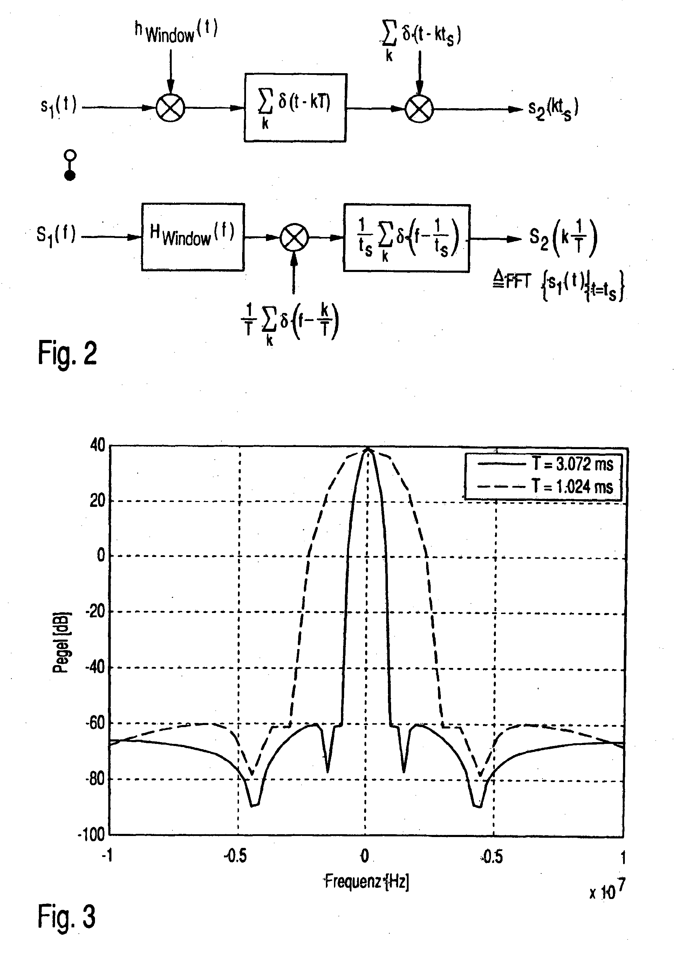

Eine diskrete Fourier-Analyse, deren Funktion anhand eines Blockschaltbildes im Zeit- und Frequenzbereich in Fig. 2 dargestellt ist, besteht im wesentlichen aus einer Fensterung des zu analysierenden Zeitsignals $s_1(t)$ mit einer Fensterfunktion $h_{Window}(t)$ mit einer Fensterlänge T, einer periodischen Fortsetzung des gefensterten Zeitsignals mit der Periode der Fensterlänge T und einer abschließenden zyklischen Abtastung des gefensterten und periodisch fortgesetzten Zeitsignals mit einer Abtastfrequenz $1/t_s$.

Im Frequenzbereich ergeben sich für die im Zeitbereich durchzuführenden Zeitfunktionen der diskreten Fourier-Analyse folgende korrespondierende Frequenzfunktionen:

Die Multiplikation des Zeitsignals $s_1(t)$ mit der Fensterfunktion $h_{Window}(t)$ entspricht einer Faltung der Fouriertransformierten $S_1(f)$ des Zeitsignals $s_1(t)$ mit der zur Fensterfunktion $h_{Window}(t)$ korrespondierenden Übertragungsfunktion $H_{Window}(f)$. Die periodische Fortsetzung des gefensterten Zeitsignals über die Periode der Fensterlänge T mittels Faltung mit einem Dirac-Kamm der Periodizität der Fensterlänge T entspricht im Frequenzbereich einer Multiplikation der Fouriertransformierten des gefensterten Zeitsignals mit einem Dirac-Kamm mit der Amplitude und der Periodizität von jeweils der inversen Fensterlänge $1/T$. Schließlich ergibt die Abtastung des gefensterten und periodisch fortgesetzten Zeitsignals im Zeitbereich eine Faltung der Fouriertransformierten des gefensterten und periodisch fortgesetzten Zeitsignals mit einem Dirac Kamm mit der Amplitude und der Periodizität von jeweils der Abtastfrequenz $1/t_s$.

Das Zeitsignal $s_2(k \cdot t_s)$ am Ausgang der Fourier-Analyse, das aus einer Fensterung, periodischen Fortsetzung und Abtastung des Zeitsignals $s_1(t)$ am Eingang der diskreten Fourier-Analyse hervorgeht, entspricht im Frequenzbereich der Fouriertransformierten $S_2(k/T)$, die aus einer Fensterung, periodischen Fortsetzung und Abtastung der Fouriertransformierten $S_1(f)$ des Zeitsignals $s_1(t)$ hervorgeht.

Die Linienauflösung $1/T$ der Fouriertransformierten $S_2(k/T)$ des gefensterten, periodisch fortgesetzten und abgetasteten Zeitsignals $s_1(t)$ ist direkt proportional zur Fensterlänge $T$ der Fensterfunktion $h_{Window}(t)$. Für die Optimierung der Linienauflösung $1/T$ der Fouriertransformierten $S_2(k/T)$ ist nicht nur die Fensterlänge $T$, sondern auch die Form der Fensterfunktion $h_{Window}(t)$ maßgebend. Eine rechteckförmige Fensterfunktion $h_{Window}(t)$ mit einer Periodendauer $T$ und einer Symmetrie zu $t=0$ weist im Frequenzbereich die schmalbandigste Hauptkeule und damit die höchste Frequenzauflösung aller Fensterfunktionen auf, erstreckt sich aber aufgrund der $\sin(x)/x$-Charakteristik ihres Spektrums über einen weiten Frequenzbereich und wirkt damit oftmals störend in ein benachbartes Frequenzband. Zur Vermeidung dieses störenden Einflusses einer Rechteck-Fensterung auf benachbarte Spektren werden Fensterfunktionen mit "weicheren" Flanken im Zeitbereich - beispielsweise Gauß-, Hamming-, Hanning-, Chebyshev- und ähnliche Fensterfunktionen - benutzt.

Liegen mehrere Frequenzbänder mit jeweils unterschiedlicher Frequenzauflösung vor, so ergibt sich für die jeweilige Fensterlänge $T$ der Fensterfunktion $h_{Window}(t)$, mit der das zu messende Zeitsignal $s_1(t)$ für das jeweilige Frequenzband gefenstert wird, der in Gleichung (1) dargestellte Zusammenhang zwischen der Fensterlänge $T$ der Fensterfunktion $h_{Window}(t)$, der FFT-Länge $N_{FFT}$ der diskreten Fourier-Analyse und der Abtastfrequenz $1/t_s$, mit der das zu messende Zeitsignal $s_1(t)$ abgetastet wird:

$$T = N_{FFT} \cdot t_S \qquad\qquad (1)$$

Nach dem Ähnlichkeitssatz der Fourier-Transformation herrscht zwischen der Zeitdauer $\Delta t$ eines Zeitsignals und der Bandbreite $\Delta f$ des zugehörigen Spektrums Reziprozität. Folglich ergibt sich aus Gleichung (1) durch Invertierung der Zusammenhang zwischen der Linienauflösung $\Delta f$ im jeweiligen Frequenzband, der FFT-Länge $N_{FFT}$ der diskreten Fourier-Analyse und der Abtastfrequenz $1/t_s$ des zu messenden Zeitsignals $s_1(t)$:

$$\Delta f = \frac{1}{T} = \frac{1}{N_{FFT} \cdot t_S} = \frac{f_S}{N_{FFT}} \qquad\qquad (2)$$

In Fig. 3 ist die Übertragungsfunktion eines Chebyshev-Fensters in einer diskreten Fourier-Analyse mit einer für alle Frequenzbänder konstanten FFT-Länge $N_{FFT}=256$ für die Fensterung eines in einem Frequenzband II mit einem Frequenzbereich von 33 kHz bis 100 kHz darzustellenden und mit der Abtastrate von 250 kHz abzutastenden Zeitsignals - gestrichelte Linie - und für die Fensterung eines in einem Frequenzband I mit einem Frequenzbereich von 10 kHz bis 33 kHz darzustellenden und mit der Abtastrate von 83,3 kHz abzutastenden identischen Zeitsignals - durchgezogene Linie - dargestellt. Die Fensterlänge $T$ der Fensterfunktion $h_{Window}(t)$ für Frequenzband II ergibt sich gemäß Gleichung (1) zu 1,024 ms, für Frequenzband I zu 3,072 ms. Wie aus Fig. 2 ersichtlich ist, weist demnach die Übertragungsfunktion des Chebyshev-Fenster im höherfrequenten Frequenzband II eine größere Bandbreite als im niederfrequenten Frequenzband I auf und resultiert damit in einer niedrigeren Frequenzauflösung des Frequenzbandes II gegenüber dem Frequenzband I.

Die Multiplikation des Zeitsignals $s_1(t)$ mit der Fensterfunktion $h_{Window}(t)$ entspricht einer Faltung der Fouriertransformierten $S_1(f)$ des Zeitsignals $s_1(t)$ mit der Fouriertransformierten $H_{Window}(f)$ der Fensterfunktion $h_{Window}(t)$. Die diskrete Faltung eines diskreten Spektralwerts der Fouriertransformierten $S_1(k)$ mit der diskreten Übertragungsfunktion $H_{window}(k)$ der diskreten Fensterfunktion $h_{Window}(k)$ kann folglich als gleitende Mittelung über die jeweils benachbarten diskreten Spektralwerte der diskreten Fouriertransformierten $S_1(k)$ des diskreten Zeitsignals $s_1(k)$ mit dem jeweiligen Spektralwert der diskreten Übertragungsfunktion $H_{Window}(k)$ der diskreten Fensterfunktion $h_{Window}(k)$ als zugehöriger Gewichtungsfaktor interpretiert werden. Da sich die Fensterlänge $T$ der Fensterfunktion $h_{Window}(t)$ für höherfrequente Frequenzbänder gemäß Gleichung (1) reduziert und damit die Bandbreite der zugehörigen Übertragungsfunktion $H_{Window}(f)$ sich vergrößert, kommt es dadurch zu einer Zunahme der Mittelungslänge der gleitenden Mittelung in höherfrequenten Frequenzbändern.

Auf diese Weise sind die Mittelungslängen in benachbarten Frequenzbändern mit unterschiedlicher Frequenzauflösungen unterschiedlich lang und führen somit bei Auftreten eines schmalbandigen Spektralanteils des zu messenden Spektrums - beispielsweise eine diskrete Spektrallinie im zu messenden Spektrum - im Übergangsbereich zwischen den beiden Frequenzbändern durch die Fensterung der diskreten Fourier-Analyse zu einer Verbreiterung dieser Spektrallinie in der korrespondierenden Spektraldarstellung. Dabei ist die Bandbreite der verbreiterten Spektrallinie im Frequenzband mit der höheren Frequenzauflösung (durchgezogene Linie in Fig. 1) deutlich schmaler ausgeprägt als die Bandbreite der im Frequenzband mit der niedrigeren Frequenzauflösung verbreiterten Spektrallinie In Fig. 1 ist dies durch die durchgezogene Linie für den im Frequenzband mit niedrigerer Frequenzauflösung real dargestellten Spektralanteil der verbreiterten Spektrallinie und durch die gestrichelte Linie für den im Frequenzband mit höherer Frequenzauflösung nicht dargestellten restlichen Spektralanteil der im Frequenzband mit niedrigerer Frequenzauflösung verbreiterten Spektrallinie veranschaulicht. Dies führt zu der obig in der Einleitung schon erwähnten Unstetigkeit im Übergangsbereich zwischen zwei Frequenzbändern mit unterschiedlicher Frequenzauflösung (ausgefüllter und unausgefüllter Kreis der beiden benachbarten Leistungswerte an der Grenze zwischen den beiden Frequenzbändern).

Die auftretende Unstetigkeit im Frequenzspektrum zweier benachbarter Frequenzbänder mit jeweils unterschiedlicher Frequenzauflösung kann beseitigt werden, indem seine Ursache - unterschiedliche Frequenzauflösung für die beiden Frequenzbänder - beseitigt wird. Ein Gedanke liegt in der schrittweisen Anpassung der Frequenzauflösung im Übergangsbereich der beiden Frequenzbänder durch ein gleitendes Mittelungsfilter im Spektralbereich. Die Mittelungslängen bei der gleitenden Mittelung ergeben sich - im Falle der Verwendung einer Fourier-Analyse zur Spektralschätzung - aus der Bandbreite der zur Fensterfunktionen $h_{Window}(t)$ gehörigen Übertragungsfunktion $H_{Window}(f)$. Durch Einführung eines gleitenden Mittelungsfilters mit der Übertragungsfunktion $H_{MA}(f)$ wird die Frequenzauflösung nachträglich korrigiert.

Da eine nachträgliche Erhöhung der Frequenzauflösung der diskreten Fourier-Analyse im Frequenzband mit der niedrigeren Frequenzauflösung, wie weiter oben in der Einleitung schon erwähnt, nicht durchführbar ist, wird erfindungsgemäß die Frequenzauflösung der diskreten Fourier-Analyse im Frequenzband mit der höheren Frequenzauflösung schrittweise nachträglich vom Frequenzbandinneren über eine definierte Anzahl von Spektralwerten in Richtung der Frequenzbandgrenze verschlechtert. Das ursprüngliche Frequenzraster im Frequenzband mit der höheren Frequenzauflösung bleibt dabei erhalten.

Die Änderung der Frequenzauflösung der diskreten Fourier-Analyse im Frequenzband mit der höheren Frequenzauflösung erfolgt durch Filterung. An der Frequenzbandgrenze muß die Frequenzauflösung bzw. die Mittelungslänge der diskreten Fourier-Analyse für das Frequenzband mit höherer Frequenzauflösung mit der Frequenzauflösung bzw. der Mittelungslänge der diskreten Fourier-Analyse für das Frequenzband mit niedrigerer Frequenzauflösung übereinstimmen. Folglich muß an der Frequenzbandgrenze die Gesamtübertragungsfunktion der Fensterung und des nachgeschalteten gleitenden Mittelungsfilters, die einer Faltung der zur Fensterfunktion $h_{WindowhR}(t)$ gehörigen Übertragungsfunktion $H_{WindowhR}(f)$ für das Frequenzband mit der höheren Frequenzauflösung mit der Übertragungsfunktion des gleitenden Mittelungsfilters $H_{MA}(f)$ entspricht, gemäß Gleichung (3) mit der zur Fensterfunktion $h_{WindowIR}(t)$ gehörigen Übertragungsfunktion $H_{WindowIR}(f)$ für das Frequenzband mit der niedrigeren Frequenzauflösung übereinstimmen oder näherungsweise übereinstimmen.

$$H_{WindowhR}(f) * H_{MA}(f) = H_{WindowIR}(f) \qquad\qquad (3)$$

Die Übertragungsfunktion des gleitenden Mittelungsfilters $H_{MA}(f)$ kann gemäß Gleichung (4) durch Fourier-Transformation des Quotienten aus der Fensterfunktion $h_{WindowIR}(t)$ für das Frequenzband mit der niedrigeren Frequenzauflösung und der Fensterfunktion $h_{WindowhR}(t)$ für das Frequenzband mit der höheren Frequenzauflösung berechnet werden.

$$H_{MA}(f) = \Im\left\{\frac{h_{WindowIR}(t)}{h_{WindowhR}(t)}\right\} \qquad\qquad (4)$$

Näherungsweise kann die Übertragungsfunktion des gleitenden Mittelungsfilters $H_{MA}(f)$ auch gemäß Gleichung (5) aus der zur Fensterfunktionen $h_{WindowIR}(t)$ für das Frequenzband mit niedrigerer Frequenzauflösung gehörigen Übertragungsfunktion $H_{WindowIR}(f)$ gewonnen werden.

$$H_{MA}(f) \approx H_{WindowIR}(f) \qquad (5)$$

In der Praxis wird anstelle eines kontinuierlichen Spektrums $H_{MA}(f)$ des Mittelungsfilters ein diskretes Spektrum $H_{MA}(k)$ benutzt. Dieses diskrete Spektrum $H_{MA}(k)$ des Mittelungsfilters wird gemäß Gleichung (6) durch diskrete Fourier-Transformation über einen Fast-Fourier-Transformation-Algorithmus (FFT-Algorithmus) aus der diskreten Fensterfunktion $h_{WindowIR}(k)$ für das Frequenzband mit niedrigerer Frequenzauflösung berechnet.

$$H_{MA}(k) = FFT\left\{h_{WindowIR}(k)\right\} \qquad (6)$$

Für das Design des Mittelungsfilters ist zusätzlich noch die Auslegung der Filterlänge zu berücksichtigen. Die Filterlänge des Mittelungsfilters, die sich aus dem Frequenzraster und der Anzahl $2 \cdot L+1$ von diskreten Spektralwerten der Übertragungsfunktion $H_{MA}(f)$ des Mittelungsfilters ergibt, legt die Anzahl L der zu glättenden Spektralwerte im Überlagerungsbereich des Frequenzbandes mit der höheren Frequenzauflösung fest. Bei der Wahl der Filterlänge L des Mittelungsfilters, die idealerweise möglichst groß auszulegen ist, sind folgende die Filterlänge L einschränkende Aspekte zu berücksichtigen:

- auf Grund der Echtzeitverarbeitung in der Berechnung der einzelnen diskreten Spektralwerte des Mittelungsfilters ist eine praktikable Minimierung der Filterlänge L des Mittelungsfilters anzustreben,

- diskrete Spektralwerte des Mittelungsfilters im Übergangsbereich des Mittelungsfilters, deren Pegel geringer als die maximale Dynamik zwischen dem Pegel der diskreten Störlinie und dem Pegel des üblicherweise zu erwartenden Rauschteppichs liegt, ist in der Echtzeitverarbeitung nicht weiter zu berücksichtigen und verkürzt damit die Filterlänge L des Mittelungsfilters,

- um vom Mittelungsfilter eine konstante Anzahl $2 \cdot L+1$ von Spektralwerten über den gesamten Frequenzbereich zu erfassen, ist bei Auftreten einer Änderung der Spektralwertdichte - an einer Frequenzbandgrenze - die Wahl der Filterlänge L des Mittelungsfilters an die niedrigste Spektralwertdichte im gesamten Frequenzbereich anzupassen.

Da für die Darstellung des Spektrums S(f) einer zu messenden diskreten Zeitfunktion s(t) üblicherweise anstelle von diskreten komplexen Spektralwerten $\underline{S}(k)$ diskrete Leistungswerte $|\underline{S}(k)|^2$ benutzt werden, die aus einer Betragsbildung und Quadrierung der jeweiligen komplexen Spektralwerte $\underline{S}(k)$ hervorgehen, muß die diskrete Übertragungsfunktion $H_{MA}(k)$ des Mittelungsfilters in Analogie dazu ebenfalls einer Betragsbildung und Quadrierung zugeführt werden. Die gemäß Gleichung (7) betragsquadrierte Übertragungsfunktion $P_{MA}(k)$ wird zusätzlich normiert, so daß die Normierungsbedingung in Gleichung (8) erfüllt ist.

$$P_{MA}(k) = \left|H_{MA}(k)\right|^2 \qquad (7)$$

$$\sum_{k=-L}^{+L} P_{MA}(k) = 1 \qquad (8)$$

Die Normierungsbedingung in Gleichung (8) bewirkt, daß die Mittelung auf die Rauschleistung auf Grund ihrer Gleichverteilung über den ganzen Meßfrequenzbereich keine Auswirkung hat, während gleichzeitig der zur diskreten Störlinie gehörige Leistungswert auf Grund seiner singulären Verteilung im ganzen Meßfrequenzbereich von der Mittelung zielgerichtet im Verhältnis der Frequenzauflösung in den beiden benachbarten Frequenzbändern beeinflußt wird.

Die betragsquadrierte und normierte Übertragungsfunktion $P_{MA}(k)$ des Mittelungsfilters gemäß Gleichung (9) ergibt sich folglich aus Gleichung (7) unter Berücksichtigung der Normierungsbedingung in Gleichung (8).

$$P_{MA}(k) = \frac{|H_{MA}(k)|^2}{\sum_{k=-L}^{+L} |H_{MA}(k)|^2} \qquad (9)$$

Die Glättung des n-ten Leistungswertes im Übergangsbereich des Frequenzbandes mit der höheren Frequenzauflösung mittels gleitender Mittelung ergibt sich aus der Gewichtung des n-ten Leistungswertes und seinen bis zu L niederfrequent benachbarten und seinen bis zu L höherfrequent benachbarten Leistungswerten mit dem jeweils frequenzzugehörigen Spektralwert des betragsquadrierten und normierten Mittelungsfilters $P_{MA}(k)$ als Gewichtungsfaktor und der anschließender Addition gemäß Gleichung (10) :

$$\left|\underline{S}(n)\right| = \sum_{k=-L}^{+L} \left|\underline{S}(n-k)\right|^2 \cdot P_{MA}(k) = \left|S(n)\right|^2 * P_{MA}(n) \quad \text{für} \quad n=0,-1,\ldots,-L+1$$

$$(10)$$

Aus Gleichung (10) ist ersichtlich, daß die Glättung des n-ten Leistungswertes mittels gleitender Mittelung einer Faltung des n-ten Leistungswertes mit der Übertragungsfunktion $P_{MA}(n)$ des betragsquadrierten und normierten Mittelungsfilters entspricht und damit zur Faltung der zum messenden Zeitsignal s(k) gehörigen Fouriertransformierten S (k) mit der zur Fensterfunktion $h_{Window}(k)$ gehörigen Übertragungsfunktion $H_{Window}(k)$ korrespondiert.
Die mathematische Beziehung in Gleichung (10) für die Glättung des n-ten Leistungswertes setzt eine Verteilung der einzelnen Leistungswerte des Leistungsspektrums in einem äquidistanten Frequenzraster voraus. Da dies insbesondere im Übergangsbereich zwischen zwei Frequenzbändern mit unterschiedlicher Frequenzauflösung nicht gegeben ist, wird im folgenden für die Glättung der Leistungswerte im Übergangsbereich das Frequenzraster des Frequenzbandes mit der höheren Frequenzauflösung benutzt. Gemäß Fig. 4 wird folglich für die Glättung der Leistungswerte im gesamten Übergangsbereich die Frequenzrasterung des Frequenzindex 1 benutzt.
Per Definition wird festgelegt, daß die betragsquadrierte und normierte Übertragungsfunktion $P_{MA0}(k)$ des Mittelungsfilters zur Glättung des Leistungswertes an der Frequenzbandgrenze der zur Fensterfunktion $h_{WindowIR}(k)$ gehörigen Übertragungsfunktion $H_{WindowIR}(k)$ für das Frequenzband mit der niedrigeren Frequenzauflösung gemäß Gleichung (5) näherungsweise entspricht.
Die betragsquadrierte und normierte Übertragungsfunktion $P_{MA0}(k)$ des Mittelungsfilters zur Glättung des Leistungswertes an der Frequenzbandgrenze wird folglich gemäß Gleichung (6) durch diskrete Fourier-Transformation der diskreten Fensterfunktion $h_{WindowIR}(k)$ für das Frequenzband mit niedrigerer Frequenzauflösung und anschließende Betragsquadrierung und Normierung gemäß Gleichung (9) ermittelt. Ein Beispiel der betragsquadrierten Übertragungsfunktion $|H_{WindowIR}(f)|^2$ der Fensterfunktion $h_{WindowIR}(t)$ für das Frequenzband mit niedriger Frequenzauflösung mit ihrer Frequenzrasterung $\Delta f_{IR}$ als Ausgangspunkt für die Berechnung der betragsquadrierten und normierten Übertragungsfunktion $P_{MA0}(k)$ des Mittelungsfilters zur Glättung des Leistungswertes an der Frequenzbandgrenze ist in Fig. 5A dargestellt.
Für die Glättung der Leistungswerte im Übergangsbereich wird anstelle eines Mittelungsfilters mit einer konstanten Anzahl von Filterkoeffizienten in der Übertragungsfunktion $P_{MA}(k)$ die Anzahl der Filterkoeffizienten der betragsquadrierten und normierten Übertragungsfunktion $P_{MAn}(k)$ des zugehörigen Mittelungsfilter mit zunehmendem Frequenzabstand des Leistungswertes zur Frequenzbandgrenze reduziert. Die Filterlänge des Mittelungsfilters wird gemäß der Fig. 5B, 5C, 5D und 5E mit zunehmenden Abstand des zu glättenden Leistungswertes von der Frequenzbandgrenze schrittweise um die jeweils beiden äußersten Filterkoeffizienten reduziert. Auf diese Weise wird gewährleistet, daß niemals Leistungswerte außerhalb des Übergangsbereiches - Leistungswerte unterhalb von L - von einem der Mittelungsfilter gefiltert werden. In den Fig. 5B, 5C, 5D und 5E ist die gegenüber der betragsquadrierten Übertragungsfunktion $|H_{WindowIR}(f)|^2$ der Fensterfunktion $h_{WindowIR}(t)$ für das Frequenzband mit niedriger Frequenzauflösung erhöhte Frequenzauflösung $\Delta f_{hR}$ zu erkennen.
Aus den somit durch Überabtastung aus der diskreten Übertragungsfunktion $H_{MA0}(n \cdot \Delta f_{hR})$ des Mittelungsfilters an der Frequenzbandgrenze gewonnenen diskreten Übertragungsfunktionen $H_{MAn}(n \cdot \Delta f_{hR})$ der insgesamt L Mittelungsfilter werden gemäß Gleichung (12) die jeweiligen betragsquadrierten und normierten diskreten Übertragungsfunktionen $P_{MAn}(n\Delta \cdot f_{hR})$ berechnet.

$$P_{MAn}(n \bullet \Delta f_{hR}) = \frac{\left|H_{MAn}(n \bullet \Delta f_{hR})\right|^2}{\sum\limits_{k=-L}^{+L} \left|H_{MAn}(n \bullet \Delta f_{hR})\right|^2} \qquad \text{für } n=-L,\ldots,+L \qquad (12)$$

Ausgehend von Gleichung (10) lassen sich unter Berücksichtigung der betragsquadrierten und normierten Übertragungsfunktionen $P_{MAn}(k=n\cdot\Delta f_{hR})$ des jeweils n-ten Mittelungsfilters der geglättete n-te Leistungswert $\left|\overline{\underline{S}}(n)\right|$ gemäß Gleichung (13) berechnen.

$$\left|\underline{\overline{S}}(n)\right| = \sum\limits_{k=-L}^{+L} \left|\underline{\overline{S}}(n-k)\right|^2 \cdot P_{MAn}(k) = \left|\underline{S}(n)\right|^2 * P_{MAn}(n) \quad \text{für } n=0,-1,\ldots,-L+1$$

$$(13)$$

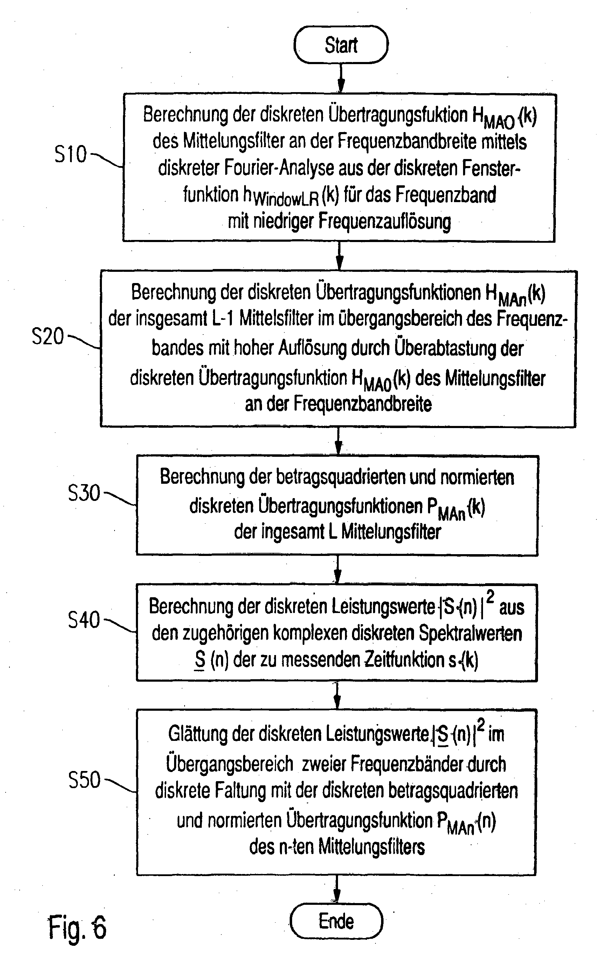

Auf der Basis der somit hergeleiteten mathematischen Grundlagen wird im folgenden das Verfahren zur Beseitigung von Unstetigkeiten im Übergangsbereich zweier Frequenzbänder unterschiedliche Frequenzauflösung in einer Spektrumanalyse gemäß Fig. 6 beschrieben.

In Verfahrensschritt S10 wird durch diskrete Fourier-Analyse der diskreten Fensterfunktion $h_{WindowIR}(k)$, welche die Fensterung für das Frequenzband mit der niedrigen Frequenzauflösung durchführt, gemäß Gleichung (6) die zugehörige diskrete Übertragungsfunktion $H_{WindowIR}(k)$ berechnet, die für die diskrete Übertragungsfunktion $H_{MA0}(k)$ des 0-ten Mittelungsfilters an der Frequenzbandgrenze zwischen den beiden Frequenzbändern mit jeweils unterschiedlicher Frequenzauflösung herangezogen wird.

Im darauffolgenden Verfahrensschritt S20 werden die diskreten Übertragungsfunktionen $H_{MAn}(k)$ der übrigen insgesamt L-1 Mittelungsfilter im Übergangsbereich des Frequenzbandes mit der höheren Frequenzauflösung berechnet. Hierzu wird die diskrete Übertragungsfunktion $H_{MA0}(k)$ des 0-ten Mittelungsfilters an der Frequenzbandgrenze benutzt, welche durch Überabtastung um den Faktor $\Delta\Delta f = \dfrac{\Delta f_{IR}}{\Delta f_{hR}}$ und schrittweise Reduzierung der Filterlänge in eine diskrete Übertragungsfunktion $H_{MAn}(k)$ des jeweiligen Mittelungsfilters mit jeweils reduzierter Anzahl von Filterkoeffizienten überführt wird.

Ist die Frequenzachse logarithmisch aufgetragen, so liegen die Spektral- bzw. Leistungswerte am oberen Rand einer Halbdekade näher beieinander als am unteren Rand einer Halbdekade. Diese Zunahme des Fequenzabstandes der einzelnen Spektral- und Leistungswerte bei logarithmischer Frequenzachse in Richtung des unteren Randes der Halbdekade wird durch die höheren Amplitudenwerte des Mittelungsfilters bei größerem Abstand zur Frequenzbandgrenze kompensiert.

Aus den in Verfahrensschritt S20 ermittelten diskreten Spektralwerten $H_{MAn}(k)$ aller insgesamt L Mittelungsfilter im Übergangsbereich des Frequenzbandes mit der höheren Frequenzauflösung werden im nachfolgenden Verfahrensschritt S30 durch Betragsbildung und Normierung gemäß Gleichung (12) die betragsquadrierten und normierten diskreten Übertragungsfunktionen $P_{MAn}(k)$ der insgesamt L Mittelungsfilter berechnet.

Während die bisherigen Verfahrensschritten S10 bis S30 offline oder bei Vorliegen eine sehr leistungsfähigen Signalprozessor-Hardware auch online berechnet werden, erfolgt die Durchführung der folgenden Verfahrensschritte S40 bis S50 stets online.

In Verfahrensschritt S40 werden aus den diskreten komplexen Spektralwerten $\underline{S}(n)$, die mittels diskreter Fourier-Analyse aus der zu messenden und abgetasteten Zeitfunktion s(k) gewonnen werden, mittels Betragsquadrierung die zugehörigen diskreten Leistungswerte $|\underline{S}(n)|^2$ berechnet.

Im abschließenden Verfahrensschritt S50 erfolgt die Berechnung der insgesamt L geglätteten Leistungswerte $\underline{S}(n)|^2$ innerhalb des Übergangbereichs des Frequenzbandes mit der höheren Frequenzauflösung mittels diskreter Faltung mit der jeweiligen diskreten betragsquadrierten und normierten Übertragungsfunktion $P_{MAn}(n)$ des n-ten Mittelungsfilters entsprechend Gleichung (13).

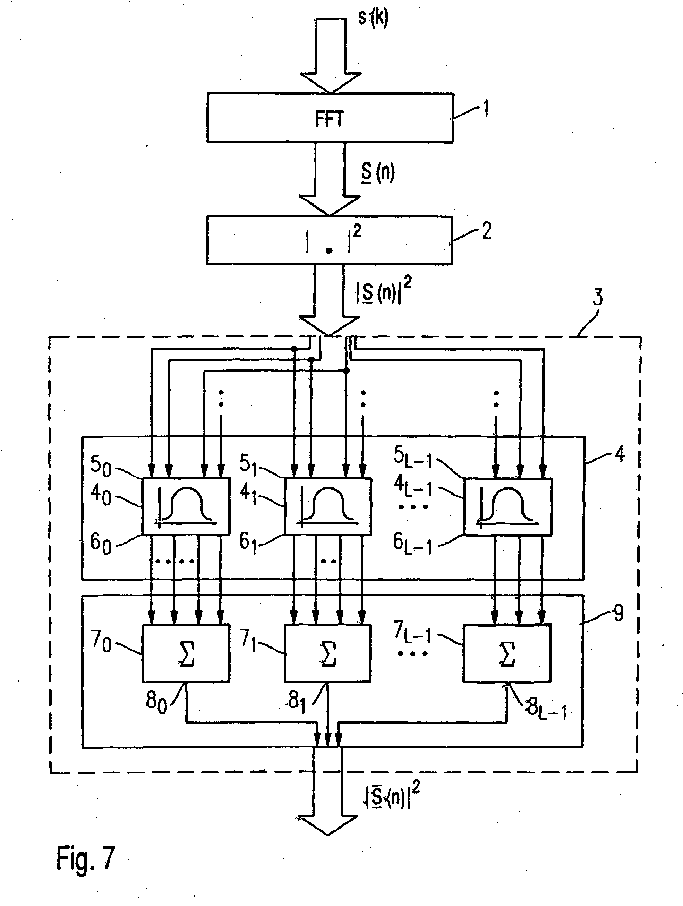

Die zugehörige Vorrichtung zur Beseitigung von Unstetigkeiten im Übergangsbereich benachbarter Frequenzbänder verschiedener Frequenzauflösung in einer Spektrumanalyse gemäß Fig. 7 besteht im wesentlichen aus einer Einheit zur Durchführung der diskreten Fourier-Analyse 1, die aus dem zu messenden abgetasteten Zeitsignal s(k) die komplexen Spektralwerte $\underline{S}(n)$ der zugehörigen Fourier-Transformierten berechnet. In einer nachfolgenden Einheit zur Betragsquadrierung 2 werden aus den komplexen Spektralwerten S(n) durch Betragsquadrierung und Mittelung die zugehörigen Leistungswerte $|\underline{S}(n)|^2$ ermittelt.

Aus den Leistungswerten $|\underline{S}(n)|^2$ der Fourier-Transformierten des abgetasteten Zeitsignals s(k) werden in der Einheit zur diskreten Faltung 3 geglättete Leitungswerte $|\underline{S}(n)|^2$ ermittelt. Die Einheit zur diskreten Faltung 3 besteht hierzu aus einer Einheit 4 zur Gewichtung der einzelnen Leistungswerte $|\underline{S}(n)|^2$, die sich wiederum aus insgesamt L Mittelungsfiltern $4_0$, $4_1$, ... , $4_{L-1}$ zusammensetzt.

Das Mittelungsfilter $4_0$ mit der Übertragungsfunktion $H_{MA0}(k)$ dient zur Glättung des Leistungswertes $|\underline{S}(n=0)|^2$ an der Frequenzbandgrenze und wird an seinem Eingang $5_0$ mit dem Leistungswert $|\underline{S}(n=0)|^2$ an der Frequenzbandgrenze und seinen insgesamt L niederfrequent benachbarten und seinen insgesamt L höherfrequenten benachbarten Leistungswerten $|\underline{S}(-L<=n<=+L)|^2$ versorgt. Analog dienen die Mittelungsfilter $4_1$ bis $4_{L-1}$ mit ihren jeweiligen Übertragungsfunktionen $H_{MA1}(k)$ bis $H_{MA(L-1)}(k)$ zur Glättung der Leistungswerte $|\underline{S}(n=-1)|^2$ bis $|\underline{S}(n=-L+1)|^2$ und werden an ihren Eingängen $5_1$ bis $5_{L-1}$ mit den jeweiligen Leistungswerten $|\underline{S}(n=-1)|^2$ bis $|\underline{S}(n=-L+1)|^2$ und den jeweils bis zu L niederfrequent benachbarten und bis zu L höherfrequent benachbarten Leistungswerten $|\underline{S}(-L<=k<=+L-2)|^2$ bis $|\underline{S}(-L<=k<=-L+2)|^2$ versorgt.

Die an den Ausgängen $6_0$, $6_1$, ... , $6_{L-1}$ der einzelnen Mittelungsfiltern $4_0$ bis $4_{L-1}$ anliegenden Bündel von zum zu glättenden Leistungswert $|\underline{S}(n)|^2$ maximal gehörigen benachbarten gewichteten Leistungswerte $|S(-L<=k<=2n+L)|^2$ werden jeweils den Summiergliedern $7_0$, $7_1$,..., $7_{L-1}$ der Einheit zu Summation 9 zugeführt. An den Ausgängen $8_0$, $8_1$,..., $8_{L-1}$ der Summierglieder $7_0$, $7_1$,..., $7_{L-1}$ liegen die geglätteten Leistungswerte $|\underline{S}(-L+1<=n<=0)|^2$ an, welche jeweils durch Summation der zum zu glättenden Leistungswert $|\underline{S}(n)|^2$ maximal gehörigen benachbarten gewichteten Leistungswerte $|S(-L<=k<=2n+L)|^2$ in den einzelnen Summiergliedern $7_0$, $7_1$,..., $7_{L-1}$ entstanden sind.

Statt einer Fast-Fourier-Transformation (FFT) können auch andere spektrale Schätzverfahren, wie z.B. der Sweepmode eines Spektrumanalysators, verwendet werden. Die diskreten Stützstellen nach Fig. 4 ergeben sich dann durch diskrete Abtastung des ermittelten Spektrums. Die Frequenzauflösung des Spektrums wird in diesem Fall nicht durch die Fouriertransformation $H_{Window}(f)$ der Fensterfunktion $h_{Window}(t)$ einer FFT bestimmt, sondern durch die Übertragungsfunktion $H_{RBW}(f)$ des verwendeten Auflösefilters im Frequenzbereich. Die Filterberechnungen im erfindungsgemäßen Verfahren erfolgen in diesem Fall analog dem beschriebenen Fall, wobei $H_{Window}(f)$ durch $H_{RBW}(f)$ ersetzt wird.

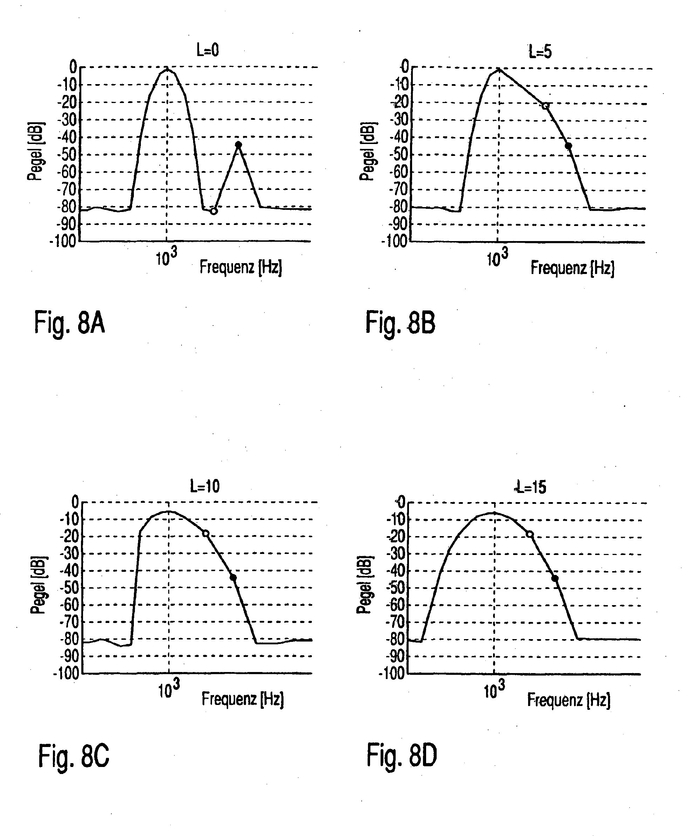

Das Ergebnis des erfindungsgemäßen Verfahrens zur Beseitigung von Unstetigkeiten im Übergangsbereich von Frequenzbändern unterschiedlicher Frequenzauflösung in einer Spektrumanalyse sind in den Figuren 8A, 8B, 8C und 8D dargestellt. Hierbei ist jeweils der Übergangsbereich zwischen zwei Frequenzbändern unterschiedlicher Frequenzauflösung, deren Grenze zwischen dem Leistungswert mit dem unausgefüllten und dem ausgefüllten Kreis liegt, im Falle einer sinusförmigen diskreten Störung bei 1000 Hz bei einer Mittelungslänge und damit einer Filterlänge L von 0, 5, 10 und 15 dargestellt. Während im vollkommen ungeglätteten Fall - L=0 in Fig. 8A - die Unstetigkeit im Übergangsbereich der Frequenzbandgrenze deutlich zu erkennen ist, wird diese Unstetigkeit mit zunehmender Mittelungslänge bzw. Filterlänge L zunehmend geglättet. Bei optimaler Glättung mit einer Mittelungslänge bzw. Filterlänge L=15 in Fig. 8D ist die Unstetigkeit im Übergangsbereich der Frequenzbänder mit unterschiedlicher Frequenzauflösung vollkommen beseitigt.

Die Erfindung ist nicht auf die dargestellte Ausführungsform beschränkt. Insbesondere wird von der Erfindung auch der Anwendungsfall abgedeckt, daß die höhere Halbdekade eine größere Auflösung als die niedrigere Halbdekade aufweist. In diesem Anwendungsfall muß die Glättung der Leistungswerte schrittweise von der höheren zur niedrigen Frequenz durch Erhöhung der Filterlänge des jeweiligen Mittelungsfilters erfolgen.

Es wird auch der Anwendungsfall abgedeckt, dass anstelle einer diskreten Fouriertransformation andere spektrale Schätzverfahren oder Messverfahren, wie z.B. der Sweepmode eines Spektrumanalysators, verwendet werden oder dass das Spektrum aneinander angrenzender Frequenzbänder mit unterschiedlichen Messverfahren vermessen wird oder verschiedene Auflösefilterarten, wie z.B. analoge und digitale Filter, verwendet werden oder dass verschiedene Fensterfunktionen, wie z. B. gaussförmige und Hamming-Fenster, verwendet werden.

## Patentansprüche

1. Verfahren zur Spektrumanalyse eines Signals ($s_1(t)$) in mehreren Frequenzbändern mit unterschiedlicher Frequenzauflösung,
   wobei die beiden Spektren des Signals ($s_1(t)$) von benachbarten Frequenzbändern im Übergangsbereich der beiden Frequenzbänder zueinander angeglichen werden,

wobei die Angleichung der beiden Spektren des Signals ($s_1(t)$) durch Glättung über eine bestimmte Anzahl (L) diskreter, komplexer Spektralwerte ($\underline{S}(-L+1<=n<=0)$) im Übergangsbereich des Frequenzbandes mit der höheren Frequenzauflösung erfolgt, wobei zur Glättung der diskreten komplexen Spektralwerte ($\underline{S}(-L+1<=n<=0)$) die zugehörigen Leistungswerte ($|\underline{S}(-L+1<=n<=0)|^2$) benutzt werden,

wobei die Glättung jedes der Leistungswerte ($|\underline{S}(-L+1<=n<=0)|^2$) durch diskrete Faltung des jeweiligen Leistungswertes ($|\underline{S}(-L+1<=n<=0)|^2$) mit einem zugehörigen diskreten Mittelungsfilter ($4_0,..,4_n,..,4_{L-1}$) erfolgt, dessen Filterlänge sich in Abhängigkeit der Frequenzlage des jeweiligen zu glättenden Leistungswertes ($|\underline{S}(-L+1<=n<=0)|^2$) schrittweise unter Beibehaltung des Frequenzrasters des Frequenzbandes mit der höheren Frequenzauflösung verändert,

wobei zur diskreten Faltung jedes der Leistungswerte ($|\underline{S}(-L+1<=n<=0)|^2$) eine vom jeweiligen zu faltenden Leistungswert ($|\overline{\underline{S}(n)}|^2$) abhängige Anzahl ($n_0(n)$) niederfrequenter und höherfrequenter benachbarter Leistungswerte ($|\underline{S}(n-n_0<=k<=n+n_0)|^2$) benutzt werden,

wobei die zur diskreten Faltung der Leistungswerte ($|\underline{S}(-L+1<=n<=-1)|^2$) benötigte Anzahl ($n_0(n)$) niederfrequenter und höherfrequenter benachbarter Leistungswerte ($|\underline{S}(n-n_0<=k<=n+n_0)|^2$) mit zunehmenden Abstand des zu glättenden Leistungswertes ($|\underline{S}(-L+1<=n<=-1)|^2$) zur Grenze der beiden Frequenzbänder jeweils um 2 dekrementiert wird, und

wobei jedes Mittelungsfilter ($4_0, ..., 4_n, ... 4_{L-1}$) eine Über-tragungsfunktion hat, die betragsquadriert und normiert wird.

2. Verfahren zur Spektrumanalyse nach Anspruch 1,
**dadurch gekennzeichnet,**
**dass** die zur diskreten Faltung des Leistungswertes ($|\underline{S}(0)|^2$) an der Grenze der beiden Frequenzbänder benötigte Anzahl ($n_0(0)$) niederfrequenter und höherfrequenter benachbarter Leistungswerte ($|\underline{S}(-n_0<=k<=+n_0)|^2$) der Anzahl (L) der im Übergangsbereich des Frequenzbandes mit der höheren Frequenzauflösung zu glättenden diskreten, komplexen Spektralwerte ($\underline{S}(-L+1<=n<=0)$) entspricht.

3. Verfahren zur Spektrumanalyse nach einem der Ansprüche 1 bis 2,
**dadurch gekennzeichnet,**
**dass** die diskrete Faltung des jeweiligen Leistungswertes ($|\underline{S}(-L+1<=n<=0)|^2$) mit seinem zugehörigen Mittelungsfilter ($4_0, ..., 4_{kn}, ..., 4_{L-1}$) durch Filterung einer bestimmten Anzahl ($n_0(n)$) nieder- und höherfrequenter benachbarter Leistungswerte ($|\underline{S}(n-n_0<=k<=n+n_0)|^2$) mit dem zum jeweiligen Leistungswert ($|\underline{S}(-L+1<=n<=0)|^2$) gehörigen Mittelungsfilter ($4_0,..,4_n,..,4_{L-1}$) und anschließende Addition erfolgt.

4. Verfahren zur Spektrumanalyse nach einem der Ansprüche 1 bis 3,
**dadurch gekennzeichnet,**
**dass** die diskrete Faltung des jeweiligen Leistungswertes ($|\underline{S}(-L+1<=n<=0)|^2$) mit dem normierten Betragsquadrat ($P_{MAn}(n)$) der diskreten Übertragungsfunktion ($H_{MAn}(n)$) des zum jeweiligen Leistungswert ($|S(n)|^2$) zugehörigen Mittelungsfilters ($4_0, .., 4_n, .., 4_{L-1}$) erfolgt.

5. Verfahren zur Spektrumanalyse nach Anspruch 4,
**dadurch gekennzeichnet,**
**dass** sich die Übertragungsfunktion ($H_{MAn}(n)$) des jeweiligen Mittelungsfilters ($4_0,..,4_n,..,4_{L-1}$), mit dem der an der Grenze der beiden Frequenzbänder befindliche Leistungswert ($|\underline{S}(0)|^2$) diskret gefaltet wird, aus einer diskreten Fourier-Transformation der diskreten, eine Fensterung des diskreten Signals ($s_1(k)$) für das Frequenzband mit niedriger Frequenzauflösung durchzuführenden Fensterfunktion ($h_{WindowIR}(k)$) ergibt.

**Claims**

1. Method for the spectrum analysis of a signal ($s_1(t)$) in a plurality of frequency bands with different frequency resolution, in which the two spectra of the signal ($s_1(t)$) of adjacent frequency bands in the transmission region of the two frequency bands are aligned with each other,

and in which the alignment of the two spectra of the signal ($s_1(t)$) is performed by smoothing over a specific number (L) of discrete, complex spectral values ($\underline{S}(-L + 1 < = n < = 0)$) in the transmission region of the frequency band with the higher frequency resolution, the associated power values ($|S(-L + 1 < = n < = 0)|^2$) being used to smooth the discrete complex spectral values ($\underline{S}(-L + 1 < = n < = 0)$),

the smoothing of each of the power values ($|\underline{S}(-L + 1 < = n < = 0)|^2$) being performed by discrete convolution of the respective power value ($|\underline{S}(-L + 1 < = n < = 0)|^2$) with the aid of an associated discrete averaging filter ($4_0$, ..., $4_n$, ... , $4_{L-1}$) whose filter length varies as a function of the frequency position of the respective power value ($|\underline{S}(-L + 1 < = n < = 0)|^2$) to be smoothed, this taking place in stepwise fashion while keeping the frequency grid of the frequency band with the higher frequency resolution,

and the discrete convolution of each of the power values ($|\underline{S}(-L + 1 < = n < = 0)|^2$) being performed by using a number ($n_0(n)$) of low frequency and higher frequency adjacent power values ($|\underline{S}(n - n_0 < = k < = n + n_0)|^2$) dependent on the respective power value $(|\overline{\underline{S}}(n)|^2)$ to be convoluted,

with the number ($n_0(n)$), required for the discrete convolution of the power values ($|\underline{S}(-L + 1 < = n < = -1)|^2$), of low frequency and higher frequency adjacent power values ($|\underline{S}(n-(n_0 < = k < = n + n_0)|^2$) being respectively decremented by 2 with increasing distance of the power value ($|\underline{S}(-L + 1 < = n < = -1)|^2$) to be smoothed from the boundary of the two frequency bands, and

each averaging filter ($4_0$, ... , $4_n$, ... $4_{L-1}$) having a transmission function which is modulus squared and normalized.

2. Method for spectrum analysis according to Claim 1, **characterized in that** the number ($n_0(0)$), required for the discrete convolution of the power value ($|\underline{S}(0)|^2$) at the boundary of the two frequency bands, of low frequency and higher frequency adjacent power values ($|\underline{S}(-n_0 < = k < = + n_0)|^2$) corresponds to the number (L) of the discrete, complex spectral values ($\underline{S}(-L + 1 < = n < = 0)$) to be smoothed in the transition region of the frequency band with the higher frequency resolution.

3. Method for spectrum analysis according to one of Claims 1 to 2, **characterized in that** the discrete convolution of the respective power value ($|\underline{S}(-L + 1 < = n < = 0)|^2$) with the aid of its associated averaging filter ($4_0$, ..., $4_{kn}$, ..., $4_{L-1}$) is performed by filtering a specific number ($n_0(n)$) of low frequency and higher frequency adjacent power values ($|\underline{S}(n -n_0 < = k < = n + n_0)|^2$) with the aid of the averaging filter ($4_0$, ..., $4_n$, ..., $4_{L-1}$) associated with the respective power value ($|\underline{S}(-L + 1 < = n < = 0)|^2$), and subsequent addition.

4. Method for spectrum analysis according to one of Claims 1 to 3, **characterized in that** the discrete convolution of the respective power value ($|\underline{S}(-L + 1 < = n < = 0)|^2$) is performed with the aid of the normalized squared modulus ($P_{MAn}(n)$) of the discrete transmission function ($H_{MAn}(n)$) of the averaging filter ($4_0$, ... , $4_n$, ..., $4_{L-1}$) associated with the respective power value ($|\underline{S}(n)|^2$).

5. Method for spectrum analysis according to Claim 4, **characterized in that** the transmission function ($H_{MAn}(n)$) of the respective averaging filter ($4_0$, ..., $4_n$, ... , $4_{L-1}$) with the aid of which the power value ($|\underline{S}(0)|^2$) located at the boundary of the two frequency bands is discretely convoluted, results from a discrete Fourier transformation of the window function ($h_{WindowIR}(k)$) which is to carry out a windowing of the discrete signal ($s_1(k)$) for the frequency band with low frequency resolution.

**Revendications**

1. Procédé d'analyse spectrale d'un signal ($s_1(t)$) dans plusieurs bandes de fréquence avec une résolution de fréquences différentes,

dans lequel les deux spectres du signal ($s_1(t)$) de bandes de fréquence adjacentes sont harmonisés dans la zone de transition des deux bandes de fréquence,

dans lequel l'harmonisation des deux spectres du signal ($s_1(t)$) est effectuée par lissage sur un nombre déterminé (L) de valeurs spectrales complexes discrètes ($\underline{S}(-L+1<=n<=0)$) dans la zone de transition de la bande de fréquence avec la résolution de fréquence la plus élevée, dans lequel les valeurs de puissance associées ($|\underline{S}(-L+1<=n<=0)|^2$) sont utilisées en vue du lissage des valeurs spectrales complexes discrètes ($\underline{S}(-L+1<=n<=0)$),

dans lequel le lissage de chacune des valeurs de puissance ($|\underline{S}(-L+1<=n<=0)|^2$) est effectué par convolution discrète de la valeur de puissance respective ($|\underline{S}(-L+1<=n<=0)|^2$) avec un filtre de moyennage discret associé ($4_0$,..., $4_n$,..., $4_{L-1}$) dont la longueur de filtre change progressivement lors de la conservation du réseau de fréquences de la bande de fréquence avec la résolution de fréquence la plus élevée en fonction de la condition de fréquence de la valeur de puissance respective à lisser ($|\underline{S}(-L+1<=n<=0)|^2$).

dans lequel un nombre ($n_0(n)$) dépendant de la valeur de puissance respective à convoluer $\left(\left|\overline{\underline{S}}(n)\right|^2\right)$ de valeurs de puissance adjacentes à basse fréquence et à fréquence plus élevée ($|\underline{S}(n-n_0<=k<=n+n_0)|^2$) est utilisé en vue d'une convolution discrète de chacune des valeurs de puissance ($|\underline{S}(-L+1<=n<=0)|^2$),

dans lequel le nombre ($n_0(n)$) nécessaire en vue de la convolution discrète des valeurs de puissance ($|\underline{S}(-L+1<=n<=-1)|^2$) des valeurs de puissance adjacentes à basse fréquence et à fréquence plus élevée ($|\underline{S}(n-n_0<=k<=n+n0)|^2$) est décrémenté respectivement de 2 avec une distance croissante de la valeur de puissance à lisser ($|\underline{S}(-L+1<=n<=-1)|^2$) jusque la limite des deux bandes de fréquence, et

dans lequel chaque filtre de moyennage ($4_0,..., 4_n,..., 4_{L-1}$) a une fonction de transmission, qui est normée et modulée au carré.

**2.** Procédé d'analyse spectrale selon la revendication 1, **caractérisé en ce que**
le nombre ($n_0(0)$) nécessaire en vue de la convolution discrète de la valeur de puissance ($|\underline{S}(0)|^2$) à la limite des deux bandes de fréquence des valeurs de puissance adjacentes à basse fréquence et à fréquence plus élevée ($|\underline{S}(-n_0<=k<=+n_0)|^2$) correspond au nombre ($L$) des valeurs spectrales complexes discrètes ($\underline{S}(-L+1<=n<=0)^2$) à lisser dans la zone de transition de la bande de fréquence avec la résolution de fréquence la plus élevée.

**3.** Procédé d'analyse spectrale selon l'une des revendications 1 à 2, **caractérisé en ce que**
la convolution discrète de la valeur de puissance respective ($|\underline{S}(-L+1<=n<=0)|^2$) est effectuée avec son filtre de moyennage associé ($4_0,..., 4_{kn},..., 4_{L-1}$) par filtrage d'un nombre déterminé ($n_0(n)$) des valeurs de puissance adjacentes à basse fréquence et à fréquence plus élevée ($|\underline{S}(n-n_0<=k<=n+n_0)|^2$) avec le filtre de moyennage ($4_0,..., 4_n,..., 4_{L-1}$) associé à la valeur de puissance respective ($|\underline{S}(-L+1<=n<=0)|^2$) ainsi que son addition ultérieure.

**4.** Procédé d'analyse spectrale selon l'une des revendications 1 à 3, **caractérisé en ce que**
la convolution discrète de la valeur de puissance respective ($|S(-L+1<=n<=0)|^2$) est effectuée avec le module au carré normé $P_{MAn}(n)$ de la fonction de transmission discrète ($H_{MAn}(n)$) du filtre de moyennage ($4_0,..., 4_n,..., 4_{L-1}$) associé à la valeur de puissance respective ($|\underline{S}(n)|^2$).

**5.** Procédé d'analyse spectrale selon la revendication 4, **caractérisé en ce que**
la fonction de transmission ($H_{MAn}(n)$) du filtre de moyennage respectif ($4_0,..., 4_n,..., 4_{L-1}$), avec lequel la valeur de puissance ($|\underline{S}(0)|^2$) se trouvant à la limite des deux bandes de fréquence est convoluée de façon discrète, a pour résultat un fenêtrage d'un signal discret ($s_1(k)$) pour la bande de fréquence avec une résolution de fréquence basse à partir d'une transformation de Fourier discrète de la fonction de fenêtre ($h_{windowIR}(k)$) effectuée discrète.

Fig. 1

$h_{Window}(t)$ $\qquad$ $\sum_k \delta(t - kt_s)$

$s_1(t) \longrightarrow \bigotimes \longrightarrow \boxed{\sum_k \delta(t-kT)} \longrightarrow \bigotimes \longrightarrow s_2(kt_s)$

$\multimap$

$S_1(f) \longrightarrow \boxed{H_{Window}(f)} \longrightarrow \bigotimes \longrightarrow \boxed{\dfrac{1}{t_s}\sum_k \delta\left(f - \dfrac{1}{t_s}\right)} \longrightarrow S_2\left(k\dfrac{1}{T}\right)$

$\dfrac{1}{T}\sum_k \delta\left(f - \dfrac{k}{T}\right)$

$\hat{=} FFT\left\{s_1(t)\big|_{t=t_s}\right\}$

## Fig. 2

Fig. 3

Fig. 4

Fig. 5A

Fig. 5B

Fig. 5C

Fig. 5D

Fig. 5E

```
                    ┌─────────────┐
                    │    Start    │
                    └──────┬──────┘
                           ↓
      ┌──────────────────────────────────────────────────┐
      │  Berechnung der diskreten Übertragungsfuktion      │
 S10  │  H_MA0(k) des Mittelungsfilter an der             │
      │  Frequenzbandbreite mittels diskreter             │
      │  Fourier-Analyse aus der diskreten Fenster-       │
      │  funktion h_WindowLR(k) für das Frequenzband      │
      │  mit niedriger Frequenzauflösung                  │
      └──────────────────────┬───────────────────────────┘
                             ↓
      ┌──────────────────────────────────────────────────┐
      │  Berechnung der diskreten Übertragungsfunktionen  │
      │  H_MAn(k) der insgesamt L-1 Mittelsfilter im      │
 S20  │  übergangsbereich des Frequenz-bandes mit hoher   │
      │  Auflösung durch Überabtastung der diskreten      │
      │  Übertragungsfunktion H_MA0(k) des Mittelungs-    │
      │  filter an der Frequenzbandbreite                 │
      └──────────────────────┬───────────────────────────┘
                             ↓
      ┌──────────────────────────────────────────────────┐
      │  Berechnung der betragsquadrierten und normierten │
 S30  │  diskreten Übertragungsfunktionen P_MAn(k)        │
      │  der ingesamt L Mittelungsfilter                  │
      └──────────────────────┬───────────────────────────┘
                             ↓
      ┌──────────────────────────────────────────────────┐
      │  Berechnung der diskreten Leistungswerte |S(n)|²  │
 S40  │  aus den zugehörigen komplexen diskreten          │
      │  Spektralwerten S(n) der zu messenden             │
      │  Zeitfunktion s(k)                                │
      └──────────────────────┬───────────────────────────┘
                             ↓
      ┌──────────────────────────────────────────────────┐
      │  Glättung der diskreten Leistungswerte |S(n)|² im │
      │  Übergangsbereich zweier Frequenzbänder durch     │
 S50  │  diskrete Faltung mit der diskreten               │
      │  betragsquadrierten und normierten                │
      │  Übertragungsfunktion P_MAn(n) des n-ten          │
      │  Mittelungsfilters                                │
      └──────────────────────┬───────────────────────────┘
                             ↓
                    ┌─────────────┐
                    │     Ende    │
                    └─────────────┘
```

**Fig. 6**

Fig. 7

Fig. 8A

Fig. 8B

Fig. 8C

Fig. 8D

**EP 1 794 601 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1271160 A1
- WO 2004001998 A1
- EP 0473949 A2